(19) Europäisches Patentamt
European Patent Office
Office européen des brevets

(11) Veröffentlichungsnummer: **0 460 291 A2**

(12) **EUROPÄISCHE PATENTANMELDUNG**

(21) Anmeldenummer: **90124246.1**

(22) Anmeldetag: **14.12.90**

(51) Int. Cl.5: **G01R 33/02**

(30) Priorität: **06.06.90 DE 4018148**

(43) Veröffentlichungstag der Anmeldung:
**11.12.91 Patentblatt 91/50**

(84) Benannte Vertragsstaaten:
**AT BE CH DE DK ES FR GB GR IT LI LU NL SE**

(71) Anmelder: **SIEMENS AKTIENGESELLSCHAFT**
**Wittelsbacherplatz 2**
**W-8000 München 2(DE)**

(72) Erfinder: **Schewe, Herbert, Dr.**
**Haydnstrasse 58**
**W-8522 Herzogenaurach(DE)**

(54) **Magnetfeldsensitive Einrichtung mit mehreren Magnetfeldsensoren.**

(57) Die magnetfeldsensitive Einrichtung (2) enthält mehrere Magnetfeldsensoren (3, 3'), die jeweils aus einem von einer Spulenwicklung (7) umschlossenen Verbundelement (6) aus zwei sich in eine Achsrichtung (A) erstreckenden ferromagnetischen Elementteilen mit uniaxialer magnetischer Anisotropie und mit unterschiedlichen Koerzitivfeldstärken bestehen. Mittels eines externen magnetischen Schaltfeldes ist nur in den Elementteilen der Verbundelemente (6) mit der kleineren Koerzitivfeldstärke eine spontane Ummagnetisierung hervorzurufen. Erfindungsgemäß sind die Magnetfeldsensoren (3, 3') zu einer Reihenanordnung (Array) zusammengefaßt, wobei die Spulenwicklungen (7) und die streifenförmigen Elementteile der zu der Reihenanordnung gehörenden Magnetfeldsensoren (3, 3') als Dünnfilmstrukturen auf einem nicht-magnetischen Substrat (4) ausgbildet sind.

FIG 1

EP 0 460 291 A2

Die Erfindung bezieht sich auf eine magnetfeldsensitive Einrichtung mit mehreren Magnetfeldsensoren, die jeweils ein von einer Spulenwicklung umschlossenes Verbundelement aus zwei sich in einer Achsrichtung erstreckenden ferromagnetischen Elementteilen enthalten, die jeweils eine uniaxiale magnetische Anisotropie mit in der Achsrichtung liegender magnetischer Vorzugsrichtung aufweisen und derart aus Materialien mit in dieser Vorzugsrichtung unterschiedlichen Koerzitivfeldstärken bestehen, daß mittels eines externen magnetischen Schaltfeldes nur in dem Elementteil mit der kleineren Koerzitivfeldstärke eine spontane Ummagnetisierung hervorzurufen ist, welche einen Spannungsimpuls in der zugeordneten Spulenwicklung erzeugt.

In der Veröffentlichung "Siemens Forsch.- u. Entwickl.-Ber.", Bd. 15 (1986) Nr. 3, Seiten 135 bis 144 ist über einen spontanen Schalteffekt in ferromagnetischen Drähten berichtet, der auf einer schnellen Ausbreitung großer Barkhausen-Sprünge basiert. Entsprechende Drähte sind z.B. die sogenannten "Wiegand-Drähte", die aus einer besonderen ferromagnetischen Legierung bestehen und tordiert sind. Insbesondere können auch spezielle Impulsdrähte derartige Schalteffekt ermöglichen. Ein solcher Impulsdraht stellt ein Verbundelement dar, das sich aus einem drahtförmigen Kern und einem diesen umschließenden Mantel zusammensetzt. Dabei besteht der Kern aus einem verhältnismäßig weichmagnetischen Material (mit einer Koerzitivfeldstärke $H_{c1}$ zwischen etwa 0,2 und 20 A/cm). Um in diesem Kern durch ein äußeres Magnetfeld, das sogenannte Schaltfeld, eine schnelle, sprungartige Flußänderung und damit eine Umkehr der Magnetisierungsrichtung hervorzurufen, muß er außerdem eine ausgeprägte uniaxiale magnetische Anisotropie mit in seiner Längsrichtung bzw. Achsrichtung liegender magnetischer Vorzugsrichtung aufweisen. Damit ferner bei einer verhältnismäßig geringen Länge des Kernes die Ausbildung von unerwünschten Abschlußdomänen verhindert wird, ist für den Mantel ein vergleichsweise magnetisch härteres Material (mit einer Koerzitvfeldstärke $H_{c2}$ von mindestens 30 A/cm) gewählt, um so den Kern permanent aufmagnetisieren zu können.

Mit einem entsprechenden Impulsdraht als einem Teil eines Magnetfeldsensors läßt sich dann eine Schalteinrichtung aufbauen. Hierzu befindet sich der Draht in einer ihn umschließenden Spulenwicklung als weiterem Teil des Magnetfeldsensors. Wird in dem Kern des Impulsdrahtes mittels eines externen magnetischen Schaltfeldes eine spontane Ummagnetisierung beim Überschreiten einer bestimmten Feldstärkeschwelle hervorgerufen (vgl. hierzu z.B. auch das Buch von E. Kneller: "Ferromagnetismus", Springer-Verlag 1962, insbesondere Seiten 401 bis 408), so wird in der Spulenwicklung ein Spannungsimpuls induziert. Dieser Spannungsimpuls kann dann mittels einer der Spulenwicklung nachgeordneten Auswerteelektronik einen Steuer- oder Schaltvorgang auslösen. Derartige Impulsdrähte mit Durchmessern von etwa 50 bis 300 $\mu$m können somit ohne weitere Hilfsenergie als Schwellwertschalter für eine Vielzahl von Sensoraufgaben wie z.B. für Drehzahlgeber, lineare Weggeber oder lineare Stromwertgrenzgeber, zur Magnetfeldmessung oder als magnetfeldempfindliche Tasten verwendet werden.

Eine magnetfeldsensitive Einrichtung, die mit mehreren derartiger Magnetfeldsensoren die eingangs genannten Merkmale aufweist, ist z.B. aus dem Prospekt der Firma Siemens AG bezüglich "SIPULS-Drehzahlgeber mit Impulsdrähten" bekannt. Diese Einrichtung enthält auf einem mit einer Welle eines Motors gekoppelten Geberrad befindliche Paare von Setz- und Rücksetzmagneten. Diese Magneten werden bei Drehung des Geberrades an mehreren ortsfesten Magnetfeldsensoren vorbeigeführt. Nähert sich nun z.B. ein Setzmagnet einem Magnetfeldsensor, so wird in dessen Impulsdraht die Schaltfeldstärke überschritten und in der um den Impulsdraht gewickelten Spulenwicklung ein Spannungsimpuls erzeugt. Anschließend wird der Impulsdraht durch das Rücksetzfeld eines Rücksetzmagneten wieder in die magnetische Ausgangslage gebracht. Ein Spannungsimpuls tritt also nur dann auf, falls sich ein Setzmagnet dem Impulsdraht nähert. Da bei der bekannten Einrichtung mehrere solcher Magnetfeldsensoren vorhanden sind, kann die Drehrichtung aus der Reihenfolge der an den Magnetfeldsensoren erzeugten Spannungsimpulse erkannt werden.

Es hat sich jedoch gezeigt, daß die bekannten Impulsdrähte und die sie umgebenden Spulenwicklungen nur mit verhältnismäßig großem Aufwand herstellbar sind und außerdem sich in den Drähten die magnetischen Eigenschaften, insbesondere die geforderten Anisotropieverhältnisse, mit hinreichender Exaktheit nur schwer reproduzierbar einstellen lassen. Dies hat zur Folge, daß die von den Magnetfeldsensoren des gleichen Aufbaus innerhalb einer magnetfeldsensitiven Einrichtung erzeugten Impulse vielfach recht unterschiedlich sind.

Aufgabe der vorliegenden Erfindung ist es deshalb, die magnetfeldsensitive Einrichtung mit den eingangs genannten Merkmalen dahingehend auszugestalten, daß die genannten Probleme vermindert sind.

Diese Aufgabe wird erfindungsgemäß dadurch gelöst, daß die Magnetfeldsensoren zu mindestens einer Reihenanordnung (Array) zusammengefaßt sind, wobei die Spulenwicklungen und die Streifenform aufweisenden ferromagnetischen Elementteile der zu der Reihenanordnung gehörenden Magnetfeldsensoren als Dünnfilm-Strukturen auf einem Substrat aus nicht-magnetischem Material ausgebildet sind.

Die mit dieser Ausgestaltung der magnetfeldsensitiven Einrichtung verbundenen Vorteile sind insbesondere darin zu sehen, daß die Dünnfilm-Technik hohen Anforderungen an die Genauigkeit einer Strukturierung und an die Reproduzierbarkeit der magnetischen Eigenschaften genügen kann und eine verhältnismäßig preiswerte Serienfertigung ermöglicht. Es lassen sich deshalb Sensoren mit großer lateraler Auflösung und definierten Impulsverhältnissen aufbauen, so daß sie innerhalb der Reihenanordnung gleichwertige Elemente darstellen. Mit solchen Reihenanordnungen können vorteilhaft Drehzahlgeber, insbesondere mit Drehsinnerkennung, oder lineare Weggeber aufgebaut werden.

Vorteilhafte Weiterbildungen der erfindungsgemäßen magnetfeldsensitiven Einrichtung gehen aus den Unteransprüchen hervor.

Zur weiteren Erläuterung der Erfindung wird nachfolgend auf die schematische Zeichnung Bezug genommen. Dabei ist in Figur 1 ein Teil einer erfindungsgemäßen magnetfeldsensitiven Einrichtung dargestellt. Figur 2 zeigt den prinzipiellen Aufbau eines schichtförmigen Verbundelementes eines Magnetfeldsensors dieser Einrichtung. In den Diagrammen der Figuren 3 und 4 sind die Hysteresiskurven von entsprechenden Verbundelementen wiedergegeben. Aus Figur 5 geht der prinzipielle Aufbau eines Drehzahlgebers mit einer erfindungsgemäßen magnetfeldsensitiven Einrichtung hervor. In Figur 6 ist ein Ausschnitt aus diesem Drehzahlgeber veranschaulicht. Das Diagramm der Figur 7 zeigt mit einem solchen Drehzahlgeber zu erzeugende Impulsspannungen. In Figur 8 ist ein Ausschnitt aus einem weiteren Drehzahlgeber dargestellt. Die mit diesem Drehzahlgeber hervorzurufenden Impulsspannungen gehen aus den Diagrammen der Figuren 9 und 10 hervor. In den Figuren sind sich entsprechende Teile mit denselben Bezugszeichen versehen.

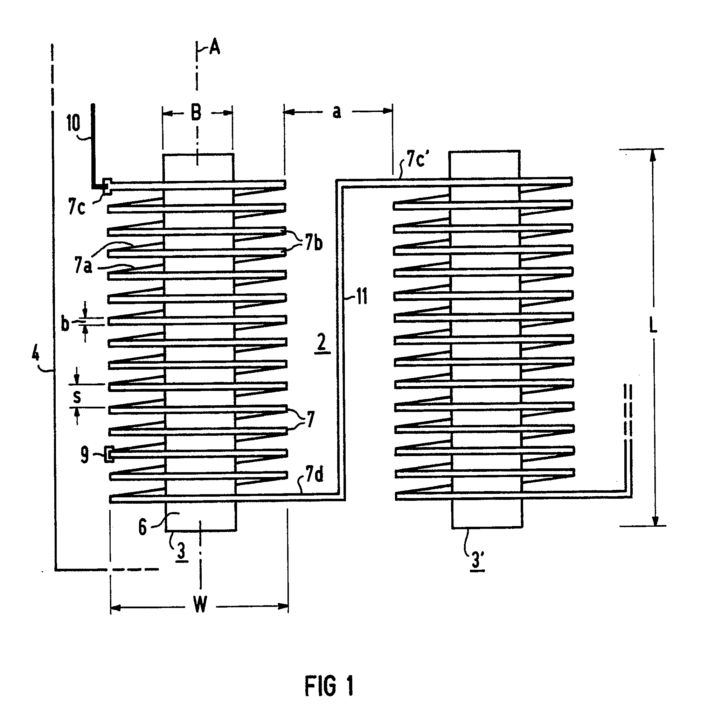

Der in Figur 1 in Aufsicht gezeigte Teil einer nachfolgend als Sensoreinrichtung bezeichneten magnetfeldsensitiven Einrichtung 2 nach der Erfindung zeigt zwei praktisch identische Magnetfeldsensoren 3 und 3'. Diese Magnetfeldsensoren sind gegenseitig um einen Abstand a beabstandet, der z.B. zwischen 0,1 und 1 mm liegen kann. Eine erfindungsgemäße Sensoreinrichtung weist im allgemeinen eine wesentlich größere Anzahl von Magnetfeldsensoren als in Figur 1 gezeigt auf. Alle diese Magnetfeldsensoren sollen erfindungsgemäß in Dünnfilm-Technik auf einem nicht näher ausgeführten Substrat 4 aus nicht-magnetischem Material erstellt sein und dort eine Reihenanordnung, ein sogenanntes "Array", bilden. Unter dem Array wird dabei eine auf einer Oberfläche des Substrates verhältnismäßig dichte Anordnung zumindest weitgehend baugleicher Sensoren verstanden. Von dieser Reihenanordnung ist nachfolgend der an einem Rand des Substrates 4 befindliche Magnetfeldsensor 3 näher erläutert.

Der Magnetfeldsensor 3 setzt sich im wesentlichen aus einem schichtförmigen Verbundelement 6 und einer dieses Element umschließenden Spulenwicklung 7 zusammen. Das schichtförmige Verbundelement 6 hat in Richtung einer Achse A eine Länge L, die im allgemeinen über 1 mm und beispielsweise unter 2 cm liegt. Die quer zur Achse A zu messende Breite B des Verbundelementes kann einige Mikrometer bis 1 mm betragen. Die Weite W der Spulenwicklung 7 quer zur Achse A liegt im allgemeinen im Bereich des 1,5- bis 3-Fachen der Breite B. Dabei sollte der Minimalwert der Weite W die Größe $W_{min} = B + 20$ μm nicht unterschreiten. Es läßt sich so auf einer vorgegebenen Fläche vorteilhaft eine entsprechend große Anzahl von Magnetfeldsensoren zu einem Array anordnen. Die Länge L des Verbundelementes 6, die Leiterbreite b der einzelnen Windungen der Spulenwicklung 7 sowie die Windungssteigung s legen dann die Anzahl der möglichen Windungen der Wicklung fest. Im allgemeinen liegen die Leiterbreite b in der Größenordnung von einigen μm und die Windungssteigung s unter 10 μm. So können z.B. bei einer Windungssteigung s von 3 μm, einer Leiterbreite b von 1 μm und einer Länge L von 3 mm etwa 1000 Windungen der Wicklung 7 realisiert werden.

Zur Herstellung entsprechender Magnetfeldsensoren wie z.B. des Sensors 3 in Dünnfilm-Technik werden zunächst auf dem Substrat 4 die beispielsweise schräg zu der Achse A verlaufenden, untereinander parallelen unteren Leiterteile 7a der Wicklung 7 aus einem geeigneten Leitermaterial wie z.B. Cu, Ag oder Au abgeschieden. Darauf wird gegenüber diesen Leiterteilen isoliert eine das Verbundelement 6 bildende Schichtenfolge aus verschiedenen ferromagnetischen Materialien aufgebracht und anschließend isoliert. Über diesen Aufbau aus den unteren Leiterteilen 7a und dem Verbundelement 6 hinweg werden dann die sich etwa senkrecht zur Achse A erstreckenden oberen Leiterteile 7b ausgebildet, die dabei mit den entsprechenden unteren Leiterteilen 7a im Randbereich der Spulenwicklung 7 kontaktiert werden. Um dieses Kontaktieren zu erleichtern, ist es vorteilhaft, wenn die entsprechenden Kontaktbereiche der unteren Leiterteile 7a als verhältnismäßig großflächige Kontaktzonen, sogenannte "Kontaktpads", ausgebildet werden. In Figur 1 ist von diesen Kontaktbereichen zur Vereinfachung der Darstellung nur ein einziger näher ausgeführt und mit 9 bezeichnet. Das äußere Ende 7c der am Rand der Sensoreinrichtung 2 liegenden Spulenwicklung 7 wird ebenfalls zweckmäßig als ein solcher großflächiger Kontaktbereich gestaltet. An entsprechenden Kontaktbereichen der gesamten Reihenanordnung enden auch die elektrischen Anschlußleiter einer nachgeordneten Auswerteelektronik. Von diesen Anschlußleitern ist in der Figur nur ein mit 10 bezeichneter, mit dem Kontaktbereich 7c des Magnetfeldsensors 3 verbundener Leiter ersichtlich. Außerdem sind die einzelnen Magnetfeldsensoren der Reihenanordnung untereinander über entsprechende Leiterbahnen zusammengeschaltet. Die Figur zeigt nur eine dieser Verbindungsleiterbahnen 11 zwischen Verbindungsstellen 7d und 7c' der benachbarten Magnetfeldsensoren 3 und 3'. Alle Leiterbahnen 11 der Reihenanordnung können vorteilhaft zusammen mit den oberen Leiterteilen 7b im gleichen Arbeitsgang erstellt werden.

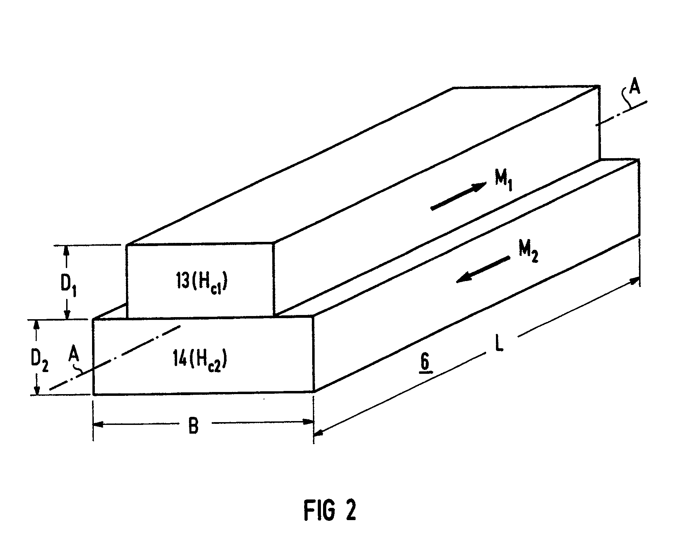

In Figur 2 ist der prinzipielle Aufbau des schichtförmigen Verbundelementes 6 des Magnetfeldsensors 3 aus Figur 1 in Schrägansicht schematisch ausgeführt. Das Verbundelement wird dabei durch ein Schichtsystem aus mindestens zwei übereinander angeordneten, streifenförmigen Elementteilen 13 und 14 gebildet. Konkrete Ausgestaltungsmöglichkeiten des Schichtsystems aus den Elementteilen 13 und 14 sind in der nicht-vorveröffentlichten DE-Patentanmeldung P 40 13 016.9 vom 24.4.90 mit dem Titel "Magnetfeldsensor einer Schalteinrichtung mit Teilen unterschiedlicher Koerzitivfeldstärke" zu entnehmen. Die beiden, nachfolgend als Magnetschichten 13 und 14 bezeichneten Elementteile dieses Schichtsystems sollen nämlich aus unterschiedlichen ferromagnetischen Materialien bestehen, die jeweils eine ausgeprägte uniaxiale magnetische Anisotropie mit in Richtung der Achse A liegender magnetischer Vorzugsrichtung und verschiedene Koerzitivfeldstärken $H_{c1}$ bzw. $H_{c2}$ (jeweils in dieser Vorzugsrichtung betrachtet) aufweisen. Hierbei sollte die Koerzitivfeldstärke $H_{c1}$ der Magnetschicht 13 wesentlich kleiner, vorzugsweise mindestens 5 mal kleiner als die Koerzitivfeldstärke $H_{c2}$ der Magnetschicht 14 sein. Im allgemeinen sind für die Magnetschicht 13 weichmagnetische Materialien mit einer Koerzitivfeldstärke $H_{c1}$ von unter 10 A/cm, vorzugsweise unter 1 A/cm geeignet. Beispiele für solche Materialien sind eine CoVFe-Legierung mit 49 Gew.-% Co und 2 Gew.-% V oder eine NiFe-Legierung mit etwa 80 Gew.-% Ni. Demgegenüber sind für die Magnetschicht 14 magnetisch härtere Materialien, insbesondere mit einer Koerzitivfeldstärke $H_{c2}$ von über 50 A/cm, vorzugsweise über 100 A/cm zu wählen. Entsprechende Materialien sind beispielsweise CoPt-, CoNi-, CoFe- oder NiCoFe-Legierungen.

Diese Magnetschichten 13 und 14 werden nach bekannten Verfahren der Dünnfilmtechnik wie z.B. durch Aufdampfen, Sputtern oder galvanische Abscheidung mit Schichtdicken $D_1$ bzw. $D_2$ von je-

weils zwischen 1 und 10 $\mu$m hergestellt. Die gewünschte uniaxiale Anisotropie kann vorteilhaft in bekannter Weise durch Formanisotropie und/oder Diffusionsanisotropie und/oder Spannungsanisotropie eingestellt werden. Sieht man beispielsweise ein Sputterverfahren vor, so können vorteilhaft die großen mechanischen Spannungen ausgenutzt werden, die bei einer Erwärmung während des Sputterns und einer sich anschließenden Abkühlung aufgrund unterschiedlicher Wärmeausdehnung der Magnetschichten und des darunterliegenden Substrates entstehen. Außerdem können Spannungen in einer Magnetschicht auch durch die Sputterparameter direkt beeinflußt werden. Darüber hinaus kann in einer Schicht eine Zugspannung aufgrund einer positiven Sättigungsmagnetostriktion eines Materials bzw. eine Druckspannung aufgrund einer negativen Magnetostriktion zu einer Spannungsanisotropie in Richtung der Achse A führen. Vorteilhaft lassen sich deshalb Materialien wählen, deren Sättigungsmagnetostriktion $\lambda_s$ ungleich null ist, wobei insbesondere $|\lambda_s| > 10^{-6}$ gelten soll.

Wie ferner in Figur 2 angedeutet ist, liegt die Magnetisierung $M_2$ der hochkoerzitiven Magnetschicht 14 in Richtung der Achse A. Diese Schicht erzeugt dann ein magnetisches Streufeld, das im Bereich der weichmagnetischen Magnetschicht 13 parallel zu deren in der Figur angenommenen Magnetisierung $M_1$ liegt. Die Richtungen der Magnetisierungen $M_1$ und $M_2$ sind dabei in der Figur durch gepfeilte Linien veranschaulicht.

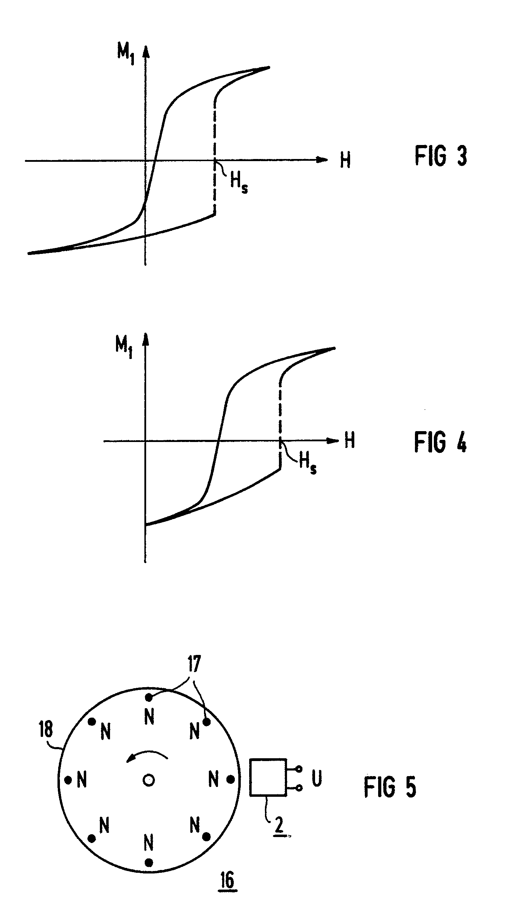

Figur 3 zeigt als Diagramm zu dem Verbundelement 6 eine zugehörende Hysteresiskurve. Dabei sind auf der Abszisse die Feldstärke H eines auf das Verbundelement einwirkenden externen Magnetfeldes und auf der Ordinate die in der Magnetschicht 13 zu beobachtende Magnetisierung $M_1$ aufgetragen. Zum Ummagnetisieren dieser Magnetschicht wird in bekannter Weise (vgl. z.B. die genannte Veröffentlichung "Siemens Forsch.- u. Entwickl.-Ber.") ein magnetisches Gegenfeld H (externes Schaltfeld) parallel zu der Magnetisierung $M_2$ angelegt, so daß beim Erreichen einer bestimmten Schwellwertfeldstärke $H_s$ durch die Magnetschicht 13 eine Ummagnetisierungsfront läuft, die in der sie umgebenden Spulenwicklung eine entsprechende Spannung induziert und die Magnetisierung $M_1$ umkehrt. Anschließend wird die Magnetschicht 13 in bekannter Weise durch ein Rücksetzfeld in den in Figur 2 gezeigten Ausgangszustand wieder zurückversetzt.

Auf ein derartiges externes Rücksetzfeld kann man dann verzichten, wenn für die hartmagnetische Magnetschicht 14 ein Material gewählt wird, dessen magnetische Remanenz $M_{r2}$ hinreichend groß ist. Eine Vergrößerung der Remanenz $M_{r2}$ gegenüber den dem Diagramm der Figur 3 zugrundegelegten Magnetisierungsverhältnissen äußert sich nämlich in einer Verschiebung der Hysteresiskurve in positiver Abszissenrichtung und ist als entsprechendes Diagramm in Figur 4 dargestellt. Dies bedeutet, daß z.B. für einen im Schnitt der Figur 5 dargestellten Drehzahlgeber 16 nur (Stab-)Magnete 17 einer Polarität N (Nordpol) erforderlich sind, um in der erfindungsgemäßen Sensoreinrichtung 2 eine Impulsspannung U zu erzeugen. Allerdings muß das Schaltfeld $H_s$ gegenüber den Verhältnissen des Diagramms der Figur 3 entsprechend erhöht sein.

Bei dem in Figur 5 gezeigten Aufbau des Drehzahlgebers 16 wird von bekannten Ausführungsformen ausgegangen (vgl. z.B. die genannte Veröffentlichung "Siemens Forsch.-u. Entwickl.-Ber."). Der Drehzahlgeber enthält eine auch als Geberrad bezeichnete nicht-magnetische Halterung 18 mit kreisförmigem Querschnitt, die an einer rotierenden Welle z.B. eines Motors zu befestigen ist und zur Aufnahme der (Stab-)Magnete 17 dient. Diese Magnete sind dabei in Umfangsrichtung der Halterung gesehen regelmäßig verteilt im Bereich des Außenrandes angeordnet und werden im Betriebsfall an der ortsfesten Sensoreinrichtung 2 nach der Erfindung vorbeigeführt. Sie rufen dort die Ummagnetisierungen in den Magnetschichten 13 ihrer Magnetfeldsensoren 3, 3' und damit in den zugeordneten Spulenwicklungen 7 die Impulsspannung U hervor.

Ein solcher Aufbau des Drehzahlgebers 16 aus Magneten 17 gleicher Polarität gewährleistet eine hohe Winkelauflösung. Ein weiterer Vorteil ergibt sich aus der einfacheren Herstellung der auf dem Kreisumfang angeordneten Magnete 17, die nach dem Zusammenbau in einem Arbeitsgang in einer Richtung aufmagnetisiert werden können. Damit ist in diesem Fall die Gefahr einer fehlerhaften Anordnung vieler alternierender Magnete, die bei bekannten Drehzahlgebern erforderlich sind, ausgeschlossen.

Eine wesentliche Vereinfachung bei der Herstellung des Drehzahlgebers 16 kann auch dadurch erzielt werden, daß die gleichpoligen Magnete 17 als hartmagnetische Schichten durch Sputtern, Plasmaspritzen oder galvanische Abscheidung auf einer Kunststoff- oder Keramik-Folie aufgebracht, mit hoher Maßhaltigkeit mit den bekannten Methoden der Mikrostrukturtechnik geätzt und schließlich auf einem Zylindermantel fixiert werden. Als hartmagnetische Materialien kommen hierzu insbesondere Schichten aus CoPt, CoNi, CoFeNi, FeSmTi, CoSm oder NdFeB in Frage.

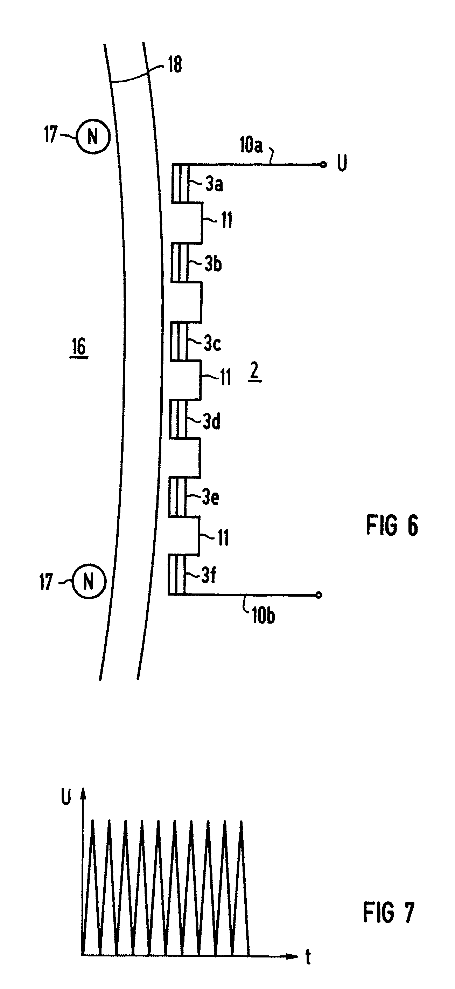

Eine weitere Steigerung der Winkelauflösung gegenüber bekannten Drehzahlgebern ist durch die erfindungsgemäße Verwendung einer Vielzahl von Magnetfeldsensoren innerhalb einer Sensoreinrichtung gewährleistet. Als ein entsprechendes Ausführungsbeispiel ist in Figur 6 ein Ausschnitt aus dem in Figur 5 gezeigten Drehzahlgeber mit einer Sensoreinrichtung 2 vergrößert veranschaulicht. In der Figur sind nur zwei Magnete 17 der gleichen Polarität N am Außenrand der Halterung 18 ersichtlich. Die Sensoreinrichtung 2 enthält sechs Magnetfeldsensoren 3a bis 3f, die eine Hysteresiskurve gemäß Figur 4 haben sollen und über Leiterbahnen 11 beispielsweise in Serie geschaltet sind. Die so an dieser Sensoreinrichtung zu erzeugende Impulsspannung U wird an Anschlußleitern 10a und 10b an den beiden äußeren Magnetfeldsensoren 3a und 3f abgegriffen. Gegebenenfalls ist es aber auch möglich, eine erfindungsgemäße Sensoreinrichtung mit mehreren Magnetfeldsensoren so auszubilden, daß die an jedem Sensor erzeugten Impulsspannungen einzeln abgenommen und in einer bekannten Summationsschaltung addiert werden.

Eine mit dem Drehzahlgeber 16 zu erzeugende Pulsfolge der Impulsspannung U ist in dem Diagramm der Figur 7 in Abhängigkeit von der Zeit t dargestellt. Das Diagramm verdeutlicht insbesondere die verhältnismäßig große Auflösung der Summenspannung bei einer erfindungsgemäßen Ausgestaltung einer Sensoreinrichtung.

Abweichend von dem den Figuren 5 bis 7 zugrundegelegten Ausführungsbeispiel ist es auch möglich, für eine erfindungsgemäße Sensoreinrichtung Magnetfeldsensoren mit einer Hysteresiskurve entsprechend dem Diagramm der Figur 3 zu verwenden. Die Auflösung der Summenspannung ist jedoch in diesem Fall durch Verdoppelung der Periodenlänge um einen Faktor 2 kleiner, da hier immer Paare von (Schalt-)Magneten unterschiedlicher Polarität erforderlich sind.

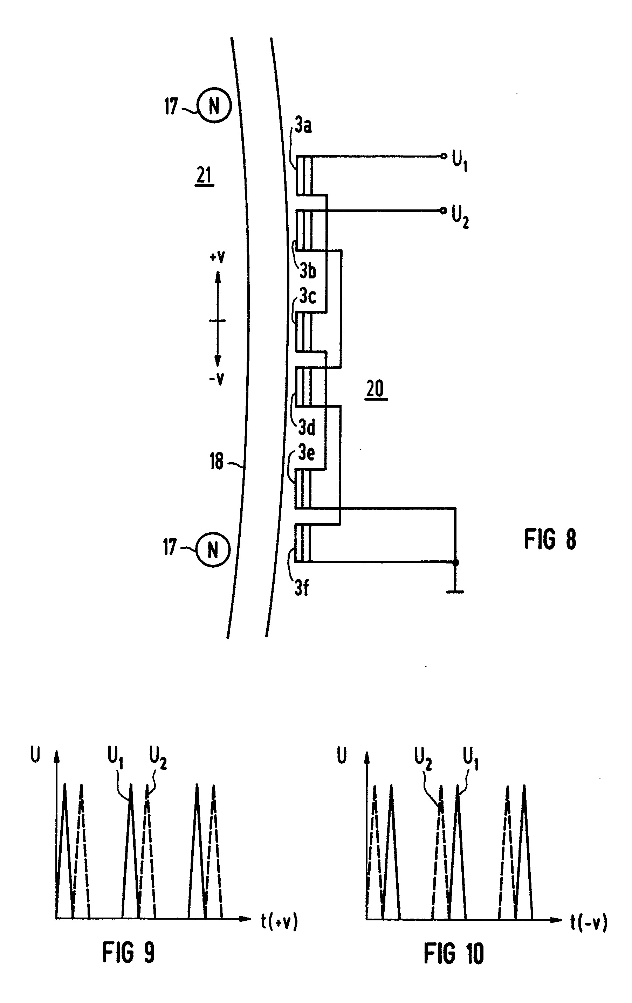

Eine erfindungsgemäße Sensoreinrichtung kann auch so ausgelegt sein, daß mit ihr der Drehsinn eines Drehzahlgebers zu erkennen ist. Ein entsprechendes Ausführungsbeispiel hierfür ist in Figur 8 angedeutet, wobei eine Figur 6 entsprechende Darstellung gewählt ist. Die mit 20 bezeichnete Sensoreinrichtung eines Drehzahlgebers 21 enthält wiederum sechs Magnetfeldsensoren 3a bis 3f, die jedoch zu zwei zahnartig ineinandergreifende Gruppen zusammengeschaltet sind. Die erste Gruppe wird dabei aus den drei hintereinandergeschalteten Magnetfeldsensoren 3a, 3c und 3e gebildet und erzeugt eine Impulsspannung $U_1$, während an der aus den Magnetfeldsensoren 3b, 3d und 3f gebildeten zweiten Gruppe eine Impulsspannung $U_2$ abzunehmen ist. Der Drehsinn der rotierenden Halterung 18 ist dabei durch zwei mit $+v$ bzw. $-v$ gekennzeichnete Pfeile veranschaulicht.

Die in Abhängigkeit vom jeweiligen Drehsinn erzeugten Impulsspannungen $U_1$ und $U_2$ gehen aus den Diagrammen der Figuren 9 und 10 hervor. In diesen Diagrammen sind die Impulsspannungen $U_1$ jeweils durch durchgezogene Linien und die Impulsspannungen $U_2$ durch gestrichelte Linien wiedergegeben. Das Diagramm der Figur 9 ergibt sich bei einem positiven Drehsinn +v, während die aus dem Diagramm der Figur 10 ersichtlichen Spannungsverhältnisse für einen negativen Drehsinn -v erhalten werden. Wie aus den beiden Diagrammen zu entnehmen ist, kehrt sich abhängig vom Drehsinn die zeitliche Abfolge zwischen den Pulsen $U_1$ und $U_2$ um und ermöglicht so eine Bestimmung des Drehsinns.

Aufgrund der in den Diagrammen der Figuren 9 und 10 gezeigten Verhältnisse der Impulsspannungen $U_1$ und $U_2$ kann eine nach Figur 8 ausgebildete Sensoreinrichtung 20 besonders vorteilhaft auch für lineare Weggeber eingesetzt werden.

## Patentansprüche

1. Magnetfeldsensitive Einrichtung mit mehreren Magnetfeldsensoren, die jeweils ein von einer Spulenwicklung umschlossenes Verbundelement aus zwei sich in einer Achsrichtung erstreckenden ferromagnetischen Elementteilen enthalten, die jeweils eine uniaxiale magnetische Anisotropie mit in der Achsrichtung liegender magnetischer Vorzugsrichtung aufweisen und derart aus Materialien mit in dieser Vorzugsrichtung unterschiedlichen Koerzitivfeldstärken bestehen, daß mittels eines externen magnetischen Schaltfeldes nur in dem Elementteil mit der kleineren Koerzitivfeldstärke eine spontane Ummagnetisierung hervorzurufen ist, welche einen entsprechenden Spannungsimpuls in der zugeordneten Spulenwicklung erzeugt, **dadurch gekennzeichnet,** daß die Magnetfeldsensoren (3, 3', 3a bis 3f) zu mindestens einer Reihenanordnung (Array) zusammengefaßt sind, wobei die Spulenwicklungen (7) und die Streifenform aufweisenden ferromagnetischen Elementteile (13, 14) der zu der Reihenanordnung gehörenden Magnetfeldsensoren als Dünnfilm-Strukturen auf einem Substrat (4) aus nicht-magnetischem Material ausgebildet sind.

2. Sensoreinrichtung nach Anspruch 1, **dadurch gekennzeichnet,** daß in jedem Magnetfeldsensor (3, 3', 3a bis 3f) der Reihenanordnung eine weichmagnetische Magnetschicht (13) des ersten Elementteils eine Koerzitivfeldstärke ($H_{c1}$) aufweist, die mindestens 5 mal kleiner ist als die Koerzitivfeldstärke ($H_{c2}$) einer hochkoerzitiven Magnetschicht (14) des zweiten Elementteils.

3. Sensoreinrichtung nach Anspruch 2, **dadurch gekennzeichnet,** daß die weichmagnetischen Magnetschichten (13) aus einem Material mit einer Koerzitivfeldstärke ($H_{c1}$) unter 10 A/cm, vorzugsweise unter 1 A/cm bestehen.

4. Sensoreinrichtung nach Anspruch 2 oder 3, **dadurch gekennzeichnet,** daß die hochkoerzitiven Magnetschichten (14) aus einem Material mit einer Koerzitivfeldstärke ($H_{c2}$) über 50 A/cm, vorzugsweise über 100 A/cm bestehen.

5. Sensoreinrichtung nach Anspruch 4, **dadurch gekennzeichnet,** daß die Koerzitivfeldstärke ($H_{c2}$) des Materials der hochkoerzitiven Magnetschichten (14) so groß ist, daß die durch das externe magnetische Schaltfeld ($H_s$) in der jeweils zugeordneten weichmagnetischen Magnetschicht (13) hervorgerufene Ummagnetisierung bei Abwesenheit des Schaltfeldes ($H_s$) rückgängig gemacht ist (vgl. Figur 4).

6. Sensoreinrichtung nach einem der Ansprüche 2 bis 5, **dadurch gekennzeichnet,** daß in den Magnetschichten (13, 14) der Magnetfeldsensoren (3, 3', 3a bis 3f) die uniaxiale magnetische Anisotropie durch Formanisotropie und/oder durch Diffusionsanisotropie und/oder durch Spannungsanisotropie eingestellt ist.

7. Sensoreinrichtung nach einem der Ansprüche 1 bis 6, **dadurch gekennzeichnet,** daß die Materialien der Verbundelemente (6) der Magnetfeldsensoren (3, 3', 3a bis 3f) eine Sättigungsmagnetostriktion $\lambda_s$ weisen, für die gilt: $|\lambda_s| > 10^{-6}$.

8. Sensoreinrichtung nach einem der Ansprüche 1 bis 7, **dadurch gekennzeichnet,** daß die Magnetfeldsensoren (3a bis 3f) der Reihenanordnung zu mehreren Gruppen (3a, 3c, 3e bzw. 3b, 3d, 3f) zusammengeschaltet sind (vgl. Fig. 8).

9. Verwendung einer Sensoreinrichtung nach einem der Ansprüche 1 bis 8 zum Erzeugen von Spannungsimpulsen in einem Drehzahlgeber (16, 21) oder in einem linearen Weggeber.

FIG 1

FIG 2

FIG 3

FIG 4

FIG 5

FIG 6

FIG 7

FIG 8

FIG 9

FIG 10